# FASCICULE DE BREVET EUROPEEN

(11) **EP 3 666 524 B1**
(45) Date de publication et mention de la délivrance du brevet: **21.04.2021**
(21) Numéro de dépôt: 19209499.3
(22) Date de dépôt: 15.11.2019
(51) Int. Cl.: B41F 15/08, B41M 1/12, B41F 15/36, H01L 31/0224, H01L 31/042, H01L 31/05, H01L 31/18, H05K 3/12

(54) **PROCEDE D'IMPRESSION PAR SERIGRAPHIE SUR UN COMPOSANT ELECTRIQUE ET/OU ELECTRONIQUE AVEC DEUX SYSTEMES DE RACLAGE**
SIEBDRUCKVERFAHREN AUF EINER ELEKTRISCHEN UND/ODER ELEKTRONISCHEN KOMPONENTE MIT ZWEI RAKELSYSTEMEN
SCREEN PRINTING PROCESS ON A ELECRIC AND/OR ELECTRONIC COMPONENT WITH TWO DOCTOR BLADE SYSTEMS

(30) Priorité: 14.12.2018 FR 1872921
(43) Date de publication de la demande: 17.06.2020
(73) Titulaire: Commissariat à l'énergie atomique et aux énergies alternatives, 75015 Paris (FR)
(72) Inventeur: REY, Nicolas, 38054 Grenoble cedex 09 (FR); COMMAULT, Benjamin, 38054 Grenoble cedex 09 (FR); DIAZ, Julien, 38054 Grenoble cedex 09 (FR); JERONIMO, Pedro, 38054 Grenoble Cedex 09 (FR)
(74) Mandataire: Brevalex

(56) Documents cités:
- EP-A1- 1 911 584
- FR-A1- 2 977 189
- US-A- 5 493 969

## Description

### DOMAINE TECHNIQUE

De façon générale, la présente invention se rapporte au domaine de l'impression par sérigraphie sur des composants électriques et/ou électroniques.

Par exemple, ces composants électriques et/ou électroniques peuvent comporter des composants optoélectroniques tels que des capteurs de type CCD (pour « Charge-Coupled Device » en anglais) ou de type CMOS (pour « Complementary Metal-Oxide-Semiconductor » en anglais), des composants montés en surface (ou de type SMD pour « Surface Mounted Device » en anglais), ou encore des composants du domaine des écrans plats, par exemple des écrans à cristaux liquides (ou LCD pour « Liquid Crystal Display » en anglais)), des écrans plasmas ou des écrans à diodes luminescentes (ou LED pour « LightEmitting Diode » en anglais).

De façon préférentielle, ces composants électriques et/ou électroniques comportent des substrats comprenant une ou plusieurs couches minces, et notamment des structures semi-conductrices monocouches ou multicouches, également dénommées « semiconductor wafers » en anglais, permettant notamment l'obtention de cellules photovoltaïques, et préférentiellement des cellules photovoltaïques dites « cristallines », c'est-à-dire qui sont à base de silicium monocristallin ou multicristallin, lorsque ces structures semi-conductrices correspondent à des plaquettes de silicium.

L'invention propose ainsi un procédé d'impression par sérigraphie sur au moins un composant électrique et/ou électronique utilisant deux systèmes de raclage.

### ÉTAT DE LA TECHNIQUE ANTÉRIEURE

Dans le domaine de la fabrication des cellules photovoltaïques, et en particulier des cellules photovoltaïques cristallines à base de silicium, il est connu de réaliser une impression sérigraphique sur des plaquettes de silicium, habituellement appelées « wafers » et à partir desquelles les cellules photovoltaïques sont obtenues. Cette impression sérigraphique constitue une étape au cours de laquelle l'impression d'électrodes conductrices à l'aide d'écrans en toile sur chacune des faces de la plaquette de silicium est réalisée. Le document US-A-5 493 969 décrit un procédé selon la préambule de la revendication 1.

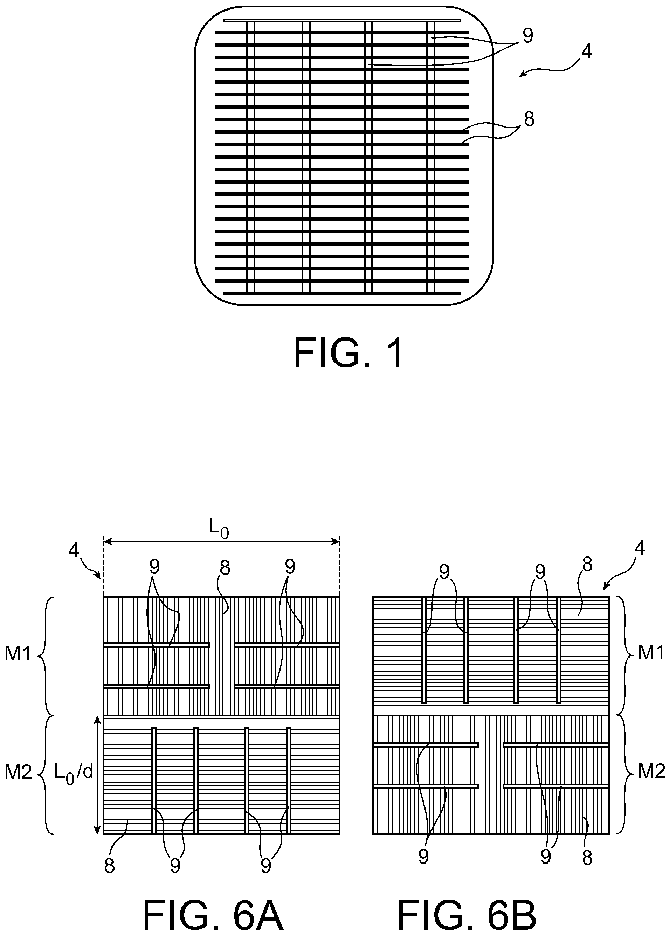

La figure 1 illustre, en vue de face, un exemple de cellule photovoltaïque 4 sur laquelle ont été imprimées par sérigraphie des lignes verticales formées par des pistes conductrices 9 dénommées « busbars » en anglais et des lignes horizontales formées par des doigts de collecte 8. Les pistes conductrices 9 sont formées en même temps que les doigts de collecte 8 et sont orientées perpendiculairement aux doigts de collecte 8.

Les interconnexions entre cellules photovoltaïques 4 sont constituées par des rubans (non représentés), habituellement réalisés en cuivre et recouverts d'un alliage fusible, typiquement un alliage d'étain et de plomb ou un alliage d'étain et d'argent. Ces rubans, de section rectangulaire, sont soudés sur les pistes conductrices 9.

Le procédé de sérigraphie de ces pistes conductrices 9 et de ces doigts de collecte 8 consiste à transférer une encre conductrice sur la plaquette de silicium au travers d'un écran par le biais d'une force appliquée sur une racle se déplaçant sur toute la longueur de l'écran. Cet écran est constitué d'une toile, le plus souvent en acier, sur laquelle est déposée une émulsion délimitant le motif à sérigraphier. Ce type de procédé est par exemple décrit dans l'article « Metallization of crystalline silicon solar cells : A review », A. Ebong et al, High Capacity Optical Networks and Enabling Technologies (HONET), 2012, 9th International Conférence on, pages 102-109.

Ainsi, de façon habituelle, les lignes formées par les doigts de collecte 8 sont sérigraphiées dans le sens du raclage pour garantir la meilleure régularité possible et surtout la meilleure finesse. Par contre, l'impression des pistes conductrices 9 étant moins critique car leurs dimensions étant très supérieures à celles des doigts de collecte 8, celle-ci peut se faire perpendiculairement au sens de raclage.

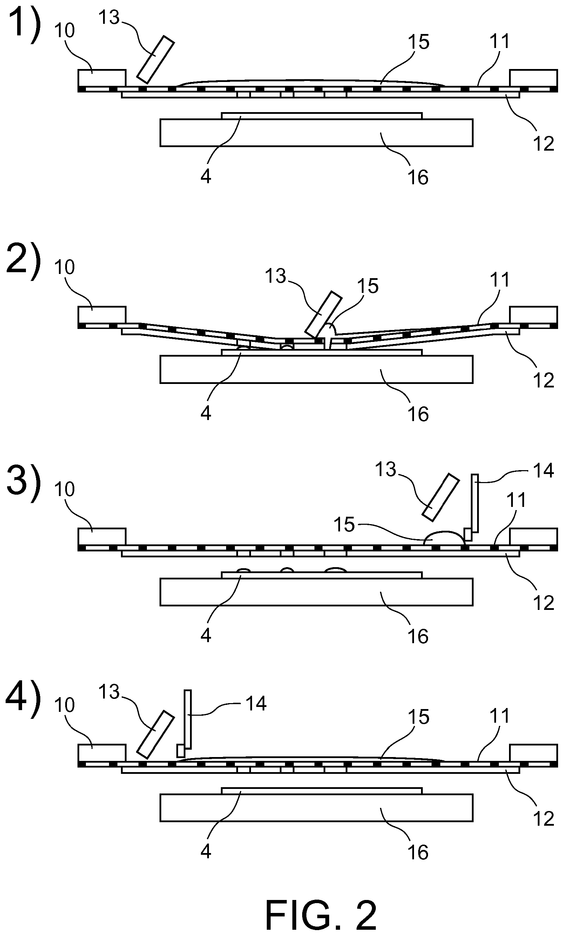

Le principe de la sérigraphie est encore illustré sur la figure 2 représentant quatre étapes 1) à 4) du procédé de sérigraphie sur des plaquettes de silicium destinées à former des cellules photovoltaïques 4. Ce procédé est également décrit dans l'article « Contact Definition in Industrial Silicon Solar Cells », Caballero, L.J., Solar Energy, février 2010, édité par Radu D. Rugescu, INTECH, ISBN 978-953-307-052-0.

L'étape 1) représente ainsi l'environnement qui est constitué par un écran 10, une toile 11 (typiquement un tissu) recouverte d'une émulsion 12, cette dernière présentant des ouvertures correspondantes aux motifs à sérigraphier, une racle 13, une contre-racle 14, une encre 15 à base métallique, la plaquette de silicium destinée à former la cellule photovoltaïque 4 et sur laquelle les motifs vont être déposés, et enfin un socle d'impression 16 maintenant la plaquette (ou « wafer »).

Au cours de l'étape 2), l'impression consiste alors à transférer de l'encre 15 de sérigraphie au travers de l'écran 10, qui comprend la toile 11 munie d'un maillage ouvert et recouverte de l'émulsion 12, par l'application d'une force sur la racle 13 en translation le long de l'écran 10. Le raclage génère alors un cordon d'encre 15 en aval de la racle 13.

Au cours de l'étape 3), en position finale ou fin de raclage, la racle 13 est remontée et la contre-racle 14 est descendue. Puis, au cours de l'étape 4), la contre-racle 14 permet de ramener l'encre 15 en position initiale et la racle 13 est également ramenée en position initiale pour une prochaine impression sur une autre plaquette de silicium.

Il est à noter que le procédé peut mettre en œuvre un mode d'impression alternée. Ainsi, le raclage s'effectue de gauche à droite, en référence à la figure 2 et à l'étape 2), puis au lieu de ramener l'encre 15 à l'aide de la contre-racle 14, la racle 13 se déplace derrière le cordon d'encre 15 afin de redémarrer un raclage de la droite vers la gauche. Alors, une nouvelle plaquette de silicium est présentée lorsque le raclage de la droite vers la gauche commence. Ce raclage alterné est souvent utilisé pour les écrans stencils où les ouvertures sont pleines, à la différence d'un écran toile où l'ouverture correspond à un maillage. En effet, le contre-raclage serait suffisant pour transférer de l'encre.

Ce principe de sérigraphie est couramment déployé en production et bien maîtrisé. Dans le cas de la sérigraphie sur des cellules photovoltaïques, les motifs sont des électrodes fines, comme décrit précédemment en référence à la figure 1, à savoir des lignes formées par des doigts de collecte et des lignes plus larges formées par des pistes conductrices ou « busbars ». La variété et le nombre de combinaisons de ces motifs sont importants, allant des motifs à n-busbars, n étant un nombre entier supérieur ou égal à 2, à des motifs sans busbar (ou « busbarless » en anglais) pour lesquels n est égal à 0.

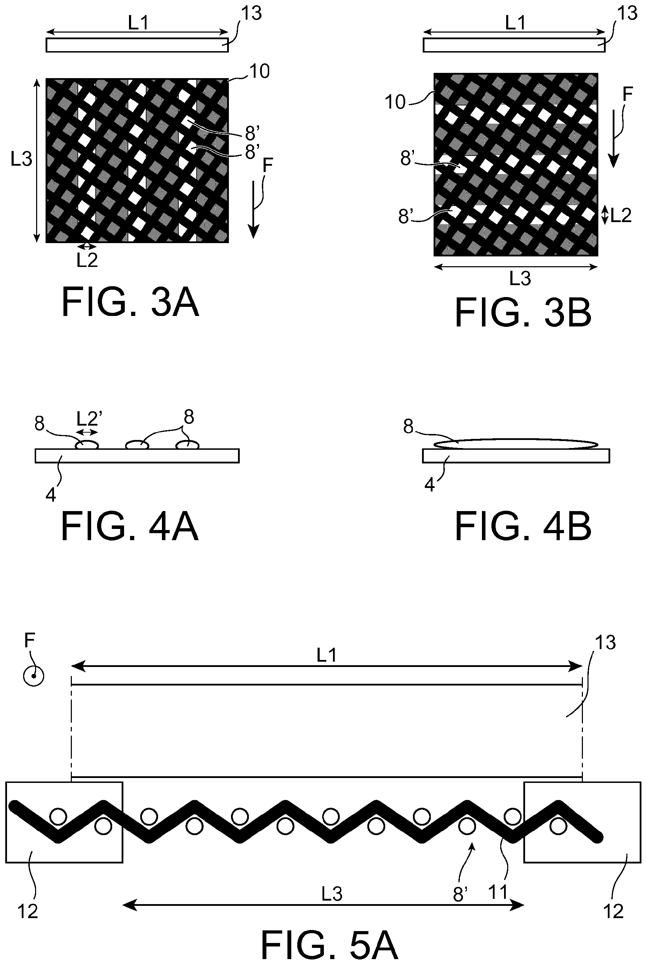

Le fait de pouvoir imprimer les lignes de sérigraphie, notamment les doigts de collecte, dans le sens du raclage permet d'assurer la meilleure finesse de celles-ci. Ainsi, en définissant un rapport d'aspect R entre la largeur L2 d'une ligne 8' de l'écran 10 (voir la figure 3A pour les références) et la largeur L2' de la même ligne 8 imprimée sur la plaquette de silicium 4, on constate que 0,6 ≤ R ≤ 1. Mais dans le cas où les lignes 8' à imprimer sont perpendiculaires au sens de raclage F, alors le rapport d'aspect R va se dégrader et R est inférieur à 0,6.

A titre d'exemples, la figure 3A illustre la racle 13, de largeur L1, et en vue de dessus, l'impression de lignes 8' sur l'écran 10 de sérigraphie dans le sens de raclage, symbolisé par la flèche F. La figure 4A illustre, selon une vue en coupe de la figure 3A, les lignes sérigraphiées 8' sur la plaquette de silicium 4.

Par ailleurs, la figure 3B illustre la racle 13, de largeur L1, et en vue de dessus, l'impression de lignes 8' sur l'écran 10 de sérigraphie dans le sens perpendiculaire au sens de raclage, symbolisé par la flèche F. La figure 4B illustre, selon une vue en coupe de la figure 3B, les lignes sérigraphiées 8' sur la plaquette de silicium 4.

Sur ces figures 3A-4B, L2 représente la largeur d'une ligne 8' de l'écran 10, soit encore l'ouverture d'une ligne 8' sur l'écran 10. L3 représente la longueur d'une ligne 8' et L2' représente la largeur finale d'une ligne imprimée 8.

Dans les deux cas, à savoir sens de raclage et sens perpendiculaire au raclage, l'impression se fait sur toute la longueur de l'écran 10. La largeur L1 de la racle 13 est de l'ordre de 160 mm, et la longueur L3 d'une ligne 8' est de l'ordre de 152 mm, soit approximativement la taille d'une plaquette de silicium. La largeur L2 d'une ligne 8' sur l'écran 10 est typiquement comprise entre 20 et 100 µm.

L'impression réalisée dans un sens perpendiculaire au sens de raclage F, comme selon les figures 3B et 4B, sera de moins bonne qualité avec un rapport d'aspect R dégradé, inférieur à 0,6.

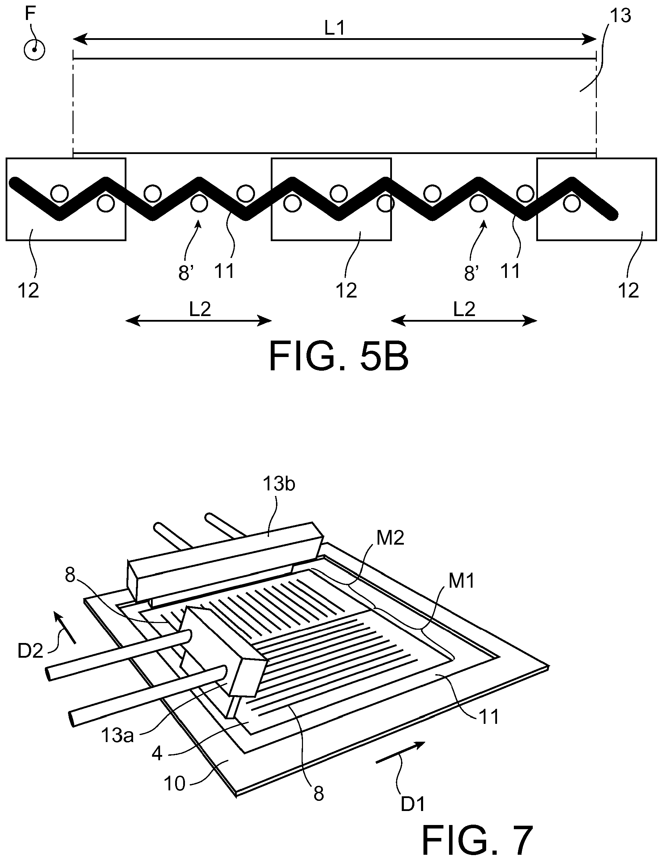

Un autre inconvénient de la réalisation d'un raclage avec des lignes fines 8' orientées à 90° du sens de raclage résulte de la baisse de la résistance mécanique de la toile 11 d'un écran 10 à toile. En effet, celle-ci est en contact sur toute la longueur de la racle 13, comme le montre la figure 5A illustrant, selon une vue en coupe, une impression par sérigraphie avec des lignes 8' orientées à 90° du sens de raclage F. Par contre, dans le cas où les lignes 8'sont dans le sens du raclage F, la toile 11 est protégée par l'émulsion 12 de l'écran 10 tous les X mm, où le paramètre X est généralement compris entre 0,5 et 2,5 mm, ce qui représente approximativement entre 60 et 300 lignes, comme l'illustre la figure 5B qui est une vue en coupe d'une impression par sérigraphie avec des lignes 8' orientées dans le sens du raclage F.

En conséquence, on comprend que fragilisée par les contraintes engendrées sur la toile 11 par un raclage perpendiculaire aux lignes 8', la durée de vie de l'écran 10 diminuera d'autant plus que l'impression se dégradera plus rapidement.

Les problèmes évoqués précédemment résultant d'une impression réalisée dans un sens perpendiculaire au sens de raclage sont notamment présents lorsque la cellule photovoltaïque 4 présente un nombre d de motifs, d étant un nombre entier supérieur ou égal à 2, caractérisés par des orientations différentes des doigts de collecte 8 et des pistes conductrices 9.

Ainsi, les figures 6A et 6B illustrent, selon des vues de face, deux exemples de cellules photovoltaïques 4 comprenant chacune un nombre d égal à 2 de motifs, l'orientation étant modifiée selon un angle de 90° entre les deux figures.

Chaque cellule photovoltaïque 4 comporte donc un premier motif M1 de type demi-cellule et un deuxième motif M2 de type demi-cellule. De plus, pour ces deux exemples, chaque cellule 4 comporte huit pistes conductrices 9, et plus précisément quatre sur chaque motif M1, M2. Par ailleurs, chaque cellule 4 présente une largeur L₀.

Alors, dans ce cas précis de motifs M1, M2 de type demi-cellule à sérigraphier avec des lignes formant les doigts de collecte 8 orientées perpendiculairement sur chaque moitié de cellule, comme visible sur les figures 6A et 6B, le raclage ne peut pas se faire de manière optimale sur l'une des deux moitiés ou autrement dit pour l'un des deux motifs M1, M2.

Trois solutions peuvent donc être envisagées. Tout d'abord, selon une première solution, il est possible de réaliser une impression classique par sérigraphie avec un seul écran correspondant au motif à sérigraphier. Cependant, la qualité d'impression des lignes formant les doigts de collecte 8 sera inégale entre les deux motifs M1, M2. Il est encore possible, selon une deuxième solution, de découper la séquence d'impression en deux temps de sorte à préserver la qualité d'impression. Toutefois, cette solution nécessite d'utiliser deux écrans et donc deux têtes de sérigraphie entraînant un doublement des étapes du procédé d'impression. De plus, cela représente un coût supérieur en production par la multiplication des écrans et des machines (par exemple, pour une production classique avec une impression en face avant et face arrière, il faudra quatre têtes d'impression).

Une troisième solution pourrait alors être envisagée, à savoir l'utilisation d'un écran avec des ouvertures différentes pour chaque motif M1, M2. Par exemple, une ouverture A des lignes de 50 µm pour la demi-cellule orientée dans le sens du raclage et une autre ouverture B plus faible de 40 µm pour compenser. Néanmoins, une telle solution nécessite un écran particulier avec une précision d'ouverture inférieure à 5 µm sans quoi cela reviendrait à mettre en œuvre la première solution décrite précédemment. De plus, cette solution repose sur une définition empirique de la dimension de l'ouverture B entraînant le risque d'imprimer des lignes de largeur différentes sur les deux demi-cellules et donc de créer de la variabilité au niveau du courant en court-circuit généré par chaque demi-cellule en raison de l'ombrage différent.

Il existe ainsi un besoin pour proposer un nouveau type de procédé d'impression par sérigraphie sur un composant électrique et/ou électronique, en particulier une plaquette de silicium destinée à former une cellule photovoltaïque, permettant de garantir, en une seule étape, une qualité d'impression égale sur tout motif du composant présentant un nombre d de motifs, d étant un nombre entier supérieur ou égal à 2. En particulier, dans les exemples précédemment décrits, il existe un besoin pour obtenir une qualité d'impression égale sur les deux demi-cellules en une seule étape d'impression.

Une solution technique a par exemple été envisagée dans le brevet américain US 5,493,969 A, utilisant un socle sur lequel repose la plaquette de silicium pouvant tourner à 90°. L'avantage est de pouvoir utiliser un seul écran avec une seule racle mais l'inconvénient majeur est de disposer d'un système permettant de déplacer la racle pour imprimer seulement le deuxième motif M2, en référence aux figures 6A et 6B, une fois l'impression du premier motif M1 et la rotation effectuées. La largeur de la racle ne convient plus ou alors il faut un écran assez grand pour déplacer la racle sans quoi on obtiendrait une surimpression. De plus, récupérer l'encre serait plus difficile, ce qui engendrerait une surconsommation. En outre, l'étape de rotation rallonge le temps de cycle du procédé.

### EXPOSÉ DE L'INVENTION

L'invention a pour but de remédier au moins partiellement aux besoins mentionnés précédemment et aux inconvénients relatifs aux réalisations de l'art antérieur.

L'invention a ainsi pour objet, selon l'un de ses aspects, un procédé d'impression par sérigraphie sur au moins un composant électrique et/ou électronique d'un nombre de motifs supérieur ou égal à deux, ce nombre étant préférentiellement un nombre entier pair, chaque motif comprenant des lignes imprimées s'étendant selon une même direction, les lignes imprimées de deux motifs juxtaposés l'un à l'autre s'étendant respectivement dans des première et deuxième directions sensiblement perpendiculaires entre elles, le procédé comprenant l'utilisation d'un écran de sérigraphie pour former les motifs sur ledit au moins un composant électrique et/ou électronique, caractérisé en ce que le procédé comporte en outre l'utilisation d'au moins un premier système de raclage et un deuxième système de raclage indépendants, configurés respectivement pour permettre le raclage selon la première direction et selon la deuxième direction pour obtenir un raclage bidirectionnel pour l'impression des motifs.

Le procédé d'impression par sérigraphie selon l'invention peut en outre comporter l'une ou plusieurs des caractéristiques suivantes prises isolément ou suivant toutes combinaisons techniques possibles.

Avantageusement, l'impression des motifs est réalisée en une seule et unique étape avec un unique écran de sérigraphie.

Par ailleurs, ledit au moins un premier système de raclage peut être configuré pour permettre le raclage selon les deux sens de la première direction et ledit au moins un deuxième système de raclage peut être configuré pour permettre le raclage selon les deux sens de la deuxième direction pour obtenir un raclage bidirectionnel alterné pour l'impression des motifs.

En outre, le procédé peut être configuré pour imprimer des lignes imprimées de largeur comprise entre 20 et 130 µm, notamment inférieure à 80 µm, notamment encore inférieure à 50 µm.

De plus, la largeur dudit au moins un composant électrique et/ou électronique peut être supérieure ou égale à 150 mm, notamment 156 mm.

Ledit au moins un premier système de raclage peut présenter une largeur L1a définie par L1a = L₀ + y, où L₀ est la largeur dudit au moins un composant électrique et/ou électronique et y vérifie la relation suivante 0 ≤ y ≤ 10 mm.

Alors, ledit au moins un deuxième système de raclage peut présenter une largeur L1b définie par L1b = y + L₀/d, où d est le nombre de motifs.

Par ailleurs, le procédé peut mettre en œuvre une séquence de déplacement desdits au moins un premier système de raclage et un deuxième système de raclage consistant à déplacer tout d'abord ledit au moins un premier système de raclage, puis alors que la course dudit premier système de raclage n'est pas terminée, notamment à mi-course, déplacer ledit au moins un deuxième système de raclage.

Le procédé peut mettre en œuvre une séquence de déplacement desdits au moins un premier système de raclage et un deuxième système de raclage comprenant, sur une durée prédéterminée, le déplacement simultané desdits au moins un premier et un deuxième systèmes de raclage.

En outre, le procédé peut tout particulièrement comporter l'étape d'impression par sérigraphie sur ledit au moins un composant électrique et/ou électronique d'un premier motif et d'un deuxième motif, chaque motif comprenant des lignes imprimées s'étendant selon une même direction, les lignes imprimées du premier motif s'étendant selon une première direction et les lignes imprimées du deuxième motif s' étendant selon une deuxième direction, les première et deuxième directions étant sensiblement perpendiculaires entre elles.

De plus, la course de raclage du premier système de raclage peut être égale à Δ + L₀/2, où Δ est compris entre 2 et 10 mm, et L₀ est la largeur dudit au moins un composant électrique et/ou électronique. De même, la course de raclage du deuxième système de raclage peut être égale à L₀ + Δ.

Ledit au moins un composant électrique et/ou électronique peut préférentiellement être une structure semi-conductrice permettant l'obtention d'une cellule photovoltaïque. Alors, les lignes imprimées peuvent constituer des doigts de collecte, et le procédé peut encore comporter encore l'étape d'impression de pistes conductrices orientées sensiblement perpendiculairement par rapport aux lignes imprimées.

Par ailleurs, le procédé peut comporter la mise en œuvre d'un système de pilotage numérique des courses desdits au moins un premier et un deuxième systèmes de raclage, ce système de pilotage numérique comportant notamment un algorithme d'anticollision.

### BRÈVE DESCRIPTION DES DESSINS

L'invention pourra être mieux comprise à la lecture de la description détaillée qui va suivre, d'un exemple de mise en œuvre non limitatif de celle-ci, ainsi qu'à l'examen des figures, schématiques et partielles, du dessin annexé, sur lequel :
[Fig. 1] - la figure 1 illustre, en vue de face, un exemple de cellule photovoltaïque sur laquelle ont été imprimées par sérigraphie des lignes verticales formées par des pistes conductrices et des lignes horizontales formées par des doigts de collecte,
[Fig. 2] - la figure 2 illustre quatre étapes 1) à 4) du procédé de sérigraphie sur des plaquettes de silicium destinées à former des cellules photovoltaïques,
[Fig. 3A] - la figure 3A illustre une racle et, en vue de dessus, l'impression de lignes sur un écran de sérigraphie dans le sens de raclage,
[Fig. 4A] - la figure 4A illustre, selon une vue en coupe de la figure 3A, les lignes sérigraphiées sur la plaquette de silicium,
[Fig. 3B] - la figure 3B illustre la racle et, en vue de dessus, l'impression de lignes sur un écran de sérigraphie dans le sens perpendiculaire au sens de raclage,
[Fig. 4B] - la figure 4B illustre, selon une vue en coupe de la figure 3B, les lignes sérigraphiées sur la plaquette de silicium,
[Fig. 5A] - la figure 5A illustre, selon une vue en coupe, une impression par sérigraphie avec des lignes orientées à 90° du sens de raclage,
[Fig. 5B] - la figure 5B illustre, selon une vue en coupe, une impression par sérigraphie avec des lignes orientées dans le sens du raclage,
[Fig. 6A] [Fig. 6B] - les figures 6A et 6B illustrent, selon des vues de face, deux exemples de cellules photovoltaïques comprenant chacune un nombre d égal à 2 de motifs, l'orientation étant modifiée selon un angle de 90° entre les deux figures,
[Fig. 7] - la figure 7 illustre, selon une vue en perspective, un exemple de principe de mise en œuvre du procédé d'impression par sérigraphie selon l'invention, et

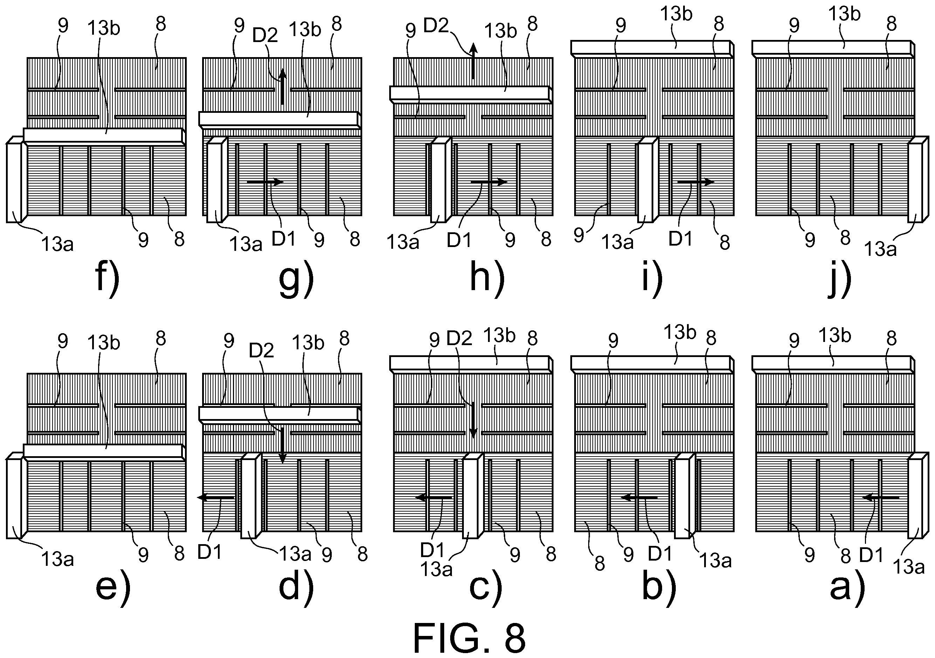

[Fig. 8] - la figure 8 illustre une séquence de raclage bidirectionnel alterné avec les premier et deuxième systèmes de raclage de la figure 7, selon les découpages a) à j) de l'étape d'impression par sérigraphie.

Dans l'ensemble de ces figures, des références identiques peuvent désigner des éléments identiques ou analogues.

De plus, les différentes parties représentées sur les figures ne le sont pas nécessairement selon une échelle uniforme, pour rendre les figures plus lisibles.

### EXPOSÉ DÉTAILLÉ D'UN MODE DE RÉALISATION PARTICULIER

Les figures 1 à 6B ont déjà été décrites dans la partie relative à l'état de la technique antérieure et au contexte technique de l'invention.

En référence à la figure 7, on a illustré, selon une vue en perspective, un exemple de principe de mise en œuvre du procédé d'impression par sérigraphie selon l'invention.

Il est à noter que, dans cet exemple et de façon nullement limitative, le composant électrique et/ou électronique est une plaquette de silicium destinée à la fabrication d'une cellule photovoltaïque 4.

Dans cet exemple encore, la cellule photovoltaïque 4 comporte deux demi-cellules et ainsi deux motifs M1 et M2 à imprimer (d = 2). Le premier motif M1 comporte une pluralité de lignes formant des doigts de collecte 8 s'étendant selon une première direction D1, et le deuxième motif M2 comporte une pluralité de lignes formant des doigts de collecte 8 s'étendant selon une deuxième direction D2, perpendiculaire à la première direction D1. En variante, il est à noter que le nombre de motifs à imprimer pourrait être supérieur à 2, étant notamment un nombre d entier pair supérieur à 2. Par exemple, la cellule photovoltaïque 4 pourrait avoir quatre quarts de cellule (d=4), ou encore huit huitièmes de cellule (d=8).

Par ailleurs, en lien avec ce qui a été décrit précédemment dans la partie relative à l'état de la technique antérieure et au contexte technique de l'invention, la sérigraphie est mise en œuvre à l'aide d'un écran de sérigraphie 10 et, par exemple d'une toile 11 recouverte d'une émulsion 12 (non représentée sur la figure 7) présentant des ouvertures correspondantes aux motifs M1, M2 à sérigraphier, d'une encre 15 (non représentée sur la figure 7), entre autres.

De plus, conformément à l'invention, le procédé utilise un premier système de raclage 13a et un deuxième système de raclage 13b indépendants l'un de l'autre. Le premier système de raclage 13a permet le raclage sur l'écran 10 selon la première direction D1, et le deuxième système de raclage 13b permet le raclage sur l'écran 10 selon la deuxième direction D2. Ainsi, les deux systèmes de raclage 13a, 13b sont placés à 90° l'un de l'autre permettant de racler chacun sur la moitié de la surface de l'écran 10. De cette façon, il peut être possible d'imprimer des lignes 8 fines, par exemple de largeur comprise entre 20 et 130 µm, par exemple inférieure à 80 µm, voire encore inférieure à 50 µm, tout en garantissant un temps de cycle rapide. En effet, du fait d'une séquence quasi-simultanée, comme décrit par la suite en référence à la figure 8, du raclage bidirectionnel, le temps de cycle est court et reste compatible avec les cadences de production des cellules photovoltaïques 4.

En effet, habituellement, le raclage se fait dans une seule et même direction au moyen d'une racle, par exemple dans un mode racle et contre-racle, voire au moyen de deux racles, par exemple dans un mode de raclage alterné. Ceci permet le raclage dans les deux sens mais toujours selon une même direction.

Grâce à l'invention, il est possible d'imprimer des motifs M1, M2 de demi-cellule photovoltaïque avec un seul écran contenant des lignes 8 orientées à 90° sur chaque moitié de la cellule 4. Il est alors possible de garantir un meilleur contrôle de l'impression sur chaque moitié de la plaquette de silicium, permettant l'obtention d'une qualité d'impression égale sur les deux demi-cellules, en une seule étape d'impression grâce à un raclage bidirectionnel, de préférence alterné, avec deux systèmes de raclage 13a, 13b, soit avec un seul poste de sérigraphie.

De façon avantageuse, l'invention permet donc l'impression de lignes imprimées 8 fines, en particulier de largeur L2' comprise entre 20 et 130 µm, notamment inférieure à 80 µm, voire encore inférieure à 50 µm.

Par ailleurs, dans l'exemple de la figure 7 et de la figure 8 décrit par la suite, la cellule photovoltaïque 4 comporte encore des pistes conductrices 9 dénommées « busbars » (visibles sur la figure 8), orientées perpendiculairement aux lignes imprimées 8 formant des doigts de collecte. En particulier, chaque motif M1, M2 comporte quatre lignes de pistes conductrices 9. En variante, il ne pourrait y avoir aucune piste conductrice 9 (configuration « busbarless » en anglais).

En outre, dans cet exemple, le premier système de raclage 13a présente une largeur L1a qui est définie par la relation suivante : L1a = L₀ + y, où L₀ est la largeur de la cellule photovoltaïque 4 et le paramètre y vérifie la relation suivante 0 ≤ y ≤ 10 mm. EN pratique, L1a peut être de l'ordre de 160 mm pour des plaquettes de silicium de taille 156 x 156 mm. Le deuxième système de raclage 13b présente alors une largeur L1b définie par la relation suivante : L1b = y + L₀/2, soit en pratique environ 80 mm.

La figure 8 illustre maintenant une séquence de raclage bidirectionnel alterné avec les premier 13a et deuxième 13b systèmes de raclage de la figure 7, selon les découpages a) à j) de l'étape d'impression par sérigraphie.

La séquence de démarrage du raclage commence par le premier système de raclage 13a, puis le deuxième système de raclage 13b, afin d'éviter d'imposer trop de contraintes sur l'écran 10 et de laisser une course de raclage du premier système de raclage 13a suffisamment grande.

En effet, dans le cas présent de deux demi-cellules (d=2), la course de raclage du premier système de raclage 13a est égale à Δ + L₀/2, où Δ est compris entre 2 et 10 mm, pour obtenir la meilleure impression. La course du deuxième système de raclage 13b est égale à L₀ + Δ.

Ainsi, dans les découpages a) à e) de la figure 8, le premier système de raclage 13a se déplace de droite à gauche selon un premier sens de la première direction D1 pour réaliser l'impression des lignes 8 du premier motif M1. Lorsque ce premier système de raclage 13a arrive à mi-course, comme selon le découpage c), le deuxième système de raclage 13b commence à se déplacer de haut en bas selon un premier sens de la deuxième direction D2 pour réaliser l'impression des lignes 8 du deuxième motif M2, terminée au niveau du découpage e).

Dans cet exemple encore, l'invention met en œuvre un raclage bidirectionnel alterné, à savoir que les premier 13a et deuxième 13b systèmes de raclage se déplacent ensuite respectivement selon l'autre sens des première D1 et deuxième D2 directions. Alors, comme selon les découpages f) à j), on observe que le deuxième système de raclage 13b se déplace de bas en haut tandis que le premier système de raclage 13a se déplace de gauche à droite à partir du découpage g) avec une vitesse de déplacement plus faible que celle du deuxième système de raclage 13b.

Un système de pilotage numérique des courses des systèmes de raclage 13a, 13b peut être prévu. Ce système peut intégrer un algorithme d'anticollision.

Bien entendu, l'invention n'est pas limitée à l'exemple de réalisation qui vient d'être décrit. Diverses modifications peuvent y être apportées par l'homme du métier.

L'encre utilisée pour la sérigraphie peut être de l'encre 15 conductrice ou de l'encre 15 isolante. De plus, l'invention s'applique à tout type d'écran 10, notamment des écrans toiles ou encore des écrans stencils, ce dernier choix étant d'autant plus intéressant qu'il n'y a pas de maille pour supporter la racle 13 lors d'un raclage à 90°.

La sérigraphie peut être bifaciale comme décrite précédemment ou encore monofaciale.

La sérigraphie peut être utilisée pour des motifs de largeur L₀ supérieure à 156 mm, et par conséquent sur des formats d'écrans plus importants.

Par ailleurs, il est à noter que chaque système de raclage 13a, 13b peut être associé à un système de contre-raclage comme selon l'art antérieur. De plus, l'impression mise en œuvre peut être classique ou bien préférentiellement alternée.

Le pilotage des deux systèmes de raclage 13a, 13b peut se faire par le biais d'axes numériques contrôlant la course de chaque système de raclage 13a, 13b.

## Revendications

1. Procédé d'impression par sérigraphie sur au moins un composant électrique et/ou électronique (4) d'un nombre (d) de motifs (M1, M2) supérieur ou égal à deux, chaque motif (M1, M2) comprenant des lignes imprimées (8) s'étendant selon une même direction (D1, D2), les lignes imprimées (8) de deux motifs (M1, M2) juxtaposés l'un à l'autre s'étendant respectivement dans des première (D1) et deuxième (D2) directions sensiblement perpendiculaires entre elles, le procédé comprenant l'utilisation d'un écran de sérigraphie (10) pour former les motifs (M1, M2) sur ledit au moins un composant électrique et/ou électronique (4),
**caractérisé en ce que** le procédé comporte en outre l'utilisation d'au moins un premier système de raclage (13a) et un deuxième système de raclage (13b) indépendants, configurés respectivement pour permettre le raclage selon la première direction (D1) et selon la deuxième direction (D2) pour obtenir un raclage bidirectionnel pour l'impression des motifs (M1, M2).

2. Procédé selon la revendication 1, **caractérisé en ce que** l'impression des motifs (M1, M2) est réalisée en une seule et unique étape avec un unique écran de sérigraphie (10).

3. Procédé selon la revendication 1 ou 2, **caractérisé en ce que** ledit au moins un premier système de raclage (13a) est configuré pour permettre le raclage selon les deux sens de la première direction (D1) et **en ce que** ledit au moins un deuxième système de raclage (13b) est configuré pour permettre le raclage selon les deux sens de la deuxième direction (D2) pour obtenir un raclage bidirectionnel alterné pour l'impression des motifs (M1, M2).

4. Procédé selon l'une des revendications précédentes, **caractérisé en ce que** le procédé est configuré pour imprimer des lignes imprimées (8) de largeur (L2') comprise entre 20 et 130 µm, notamment inférieure à 80 µm, notamment encore inférieure à 50 µm.

5. Procédé selon l'une quelconque des revendications précédentes, **caractérisé en ce que** la largeur (L₀) dudit au moins un composant électrique et/ou électronique (4) est supérieure ou égale à 150 mm, notamment 156 mm.

6. Procédé selon l'une quelconque des revendications précédentes, **caractérisé en ce que** ledit au moins un premier système de raclage (13a) présente une largeur L1a définie par L1a = L₀ + y, où L₀ est la largeur dudit au moins un composant électrique et/ou électronique (4) et y vérifie la relation suivante 0 ≤ y ≤ 10 mm.

7. Procédé selon la revendication 6, **caractérisé en ce que** ledit au moins un deuxième système de raclage (13b) présente une largeur (L1b) définie par L1b = y + L₀/d, où d est le nombre de motifs (M1, M2).

8. Procédé selon l'une quelconque des revendications précédentes, **caractérisé en ce qu'**il met en œuvre une séquence de déplacement desdits au moins un premier système de raclage (13a) et un deuxième système de raclage (13b) consistant à déplacer tout d'abord ledit au moins un premier système de raclage (13a), puis alors que la course dudit premier système de raclage (13a) n'est pas terminée, notamment à mi-course, déplacer ledit au moins un deuxième système de raclage (13b).

9. Procédé selon l'une quelconque des revendications précédentes, **caractérisé en ce qu'**il met en œuvre une séquence de déplacement desdits au moins un premier système de raclage (13a) et un deuxième système de raclage (13b) comprenant, sur une durée prédéterminée, le déplacement simultané desdits au moins un premier (13a) et un deuxième (13b) systèmes de raclage.

10. Procédé selon l'une quelconque des revendications précédentes, **caractérisé en ce qu'**il comporte l'étape d'impression par sérigraphie sur ledit au moins un composant électrique et/ou électronique (4) d'un premier motif (M1) et d'un deuxième motif (M2), chaque motif (M1, M2) comprenant des lignes imprimées (8) s'étendant selon une même direction (D1, D2), les lignes imprimées (8) du premier motif (M1) s'étendant selon une première direction (D1) et les lignes imprimées (8) du deuxième motif (M2) s' étendant selon une deuxième direction (D2), les première (D1) et deuxième (D2) directions étant sensiblement perpendiculaires entre elles.

11. Procédé selon la revendication 10, **caractérisé en ce que** la course de raclage du premier système de raclage (13a) est égale à Δ + L₀/2, où Δ est compris entre 2 et 10 mm, et L₀ est la largeur dudit au moins un composant électrique et/ou électronique (4).

12. Procédé selon la revendication 11, **caractérisé en ce que** la course de raclage du deuxième système de raclage (13b) est égale à L₀ + Δ.

13. Procédé selon l'une quelconque des revendications précédentes, **caractérisé en ce que** ledit au moins un composant électrique et/ou électronique (4) est une structure semi-conductrice permettant l'obtention d'une cellule photovoltaïque (4).

14. Procédé selon la revendication 13, **caractérisé en ce que** les lignes imprimées (8) constituent des doigts de collecte (8), et **en ce que** le procédé comporte encore l'étape d'impression de pistes conductrices (9) orientées sensiblement perpendiculairement par rapport aux lignes imprimées (8).

15. Procédé selon l'une quelconque des revendications précédentes, **caractérisé en ce qu'**il comporte la mise en œuvre d'un système de pilotage numérique des courses desdits au moins un premier (13a) et un deuxième (13b) systèmes de raclage, ce système de pilotage numérique comportant notamment un algorithme d'anticollision.

## Patentansprüche

1. Verfahren zum Drucken durch Siebdruck auf wenigstens ein elektrisches und/oder elektronisches Bauteil (4) einer Anzahl (d) von Mustern (M1, M2), die größer oder gleich zwei ist, wobei jedes Muster (M1, M2) gedruckte Linien (8) aufweist, die sich in der gleichen Richtung (D1, D2) erstrecken, wobei sich die gedruckten Linien (8) von zwei Mustern (M1, M2), die nebeneinander liegen, jeweils in einer ersten (D1) und einer zweiten (D2) Richtung im Wesentlichen senkrecht zueinander erstrecken, wobei das Verfahren die Verwendung eines Siebdruckschirms (10) umfasst, um die Muster (M1, M2) auf dem wenigstens einen elektrischen und/oder elektronischen Bauteil (4) zu bilden,
**dadurch gekennzeichnet, dass** das Verfahren ferner die Verwendung wenigstens eines ersten unabhängigen Abstreifsystems (13a) und eines zweiten unabhängigen Abstreifsystems (13b) umfasst, die jeweils dazu ausgebildet sind, ein Abstreifen in der ersten Richtung (D1) und in der zweiten Richtung (D2) zu ermöglichen, um ein bidirektionales Abstreifen zum Drucken der Muster (M1, M2) zu erhalten.

2. Verfahren nach Anspruch 1, **dadurch gekennzeichnet, dass** das Drucken der Muster (M1, M2) in einem einzigen Schritt mit einem einzigen Siebdrucksieb (10) durchgeführt wird.

3. Verfahren nach Anspruch 1 oder 2, **dadurch gekennzeichnet, dass** das wenigstens eine erste Abstreifsystem (13a) dazu ausgebildet ist, ein Abstreifen in beiden Richtungen der ersten Richtung (D1) zu erlauben, und dass das wenigstens eine zweite Abstreifsystem (13b) dazu ausgebildet ist, ein Abstreifen in beiden Richtungen der zweiten Richtung (D2) zu erlauben, um ein abwechselndes bidirektionales Abstreifen zum Drucken der Muster (M1, M2) zu erhalten.

4. Verfahren nach einem der vorhergehenden Ansprüche, **dadurch gekennzeichnet, dass** das Verfahren dazu ausgebildet ist, gedruckte Linien (8) mit einer Breite (L2') zwischen 20 und 130 µm, insbesondere kleiner 80 µm, insbesondere kleiner 50 µm, zu drucken.

5. Verfahren nach einem der vorhergehenden Ansprüche, **dadurch gekennzeichnet, dass** die Breite (L₀) des wenigstens einen elektrischen und/oder elektronischen Bauteils (4) größer gleich 150 mm, insbesondere gleich 156 mm, ist.

6. Verfahren nach einem der vorhergehenden Ansprüche, **dadurch gekennzeichnet, dass** das wenigstens eine erste Abstreifsystem (13a) eine Breite L1a aufweist, die als L1a = L₀+y definiert ist, wobei L₀ die Breite des wenigstens einen elektrischen und/oder elektronischen Bauteils (4) ist und hier die Beziehung 0 ≤ y ≤ 10 mm verifiziert.

7. Verfahren nach Anspruch 6, **dadurch gekennzeichnet, dass** das wenigstens eine zweite Abstreifsystem (13b) eine Breite (L1b) aufweist, die als L1b = y + L₀/d definiert ist, wobei d die Anzahl der Muster (M1, M2) ist.

8. Verfahren nach einem der vorhergehenden Ansprüche, **dadurch gekennzeichnet, dass** es eine Verlagerungssequenz des wenigstens einen ersten Abstreifsystems (13a) und zweiten Abstreifsystems (13b) implementiert, die darin besteht, zuerst das wenigstens eine erste Abstreifsystem (13a) zu verlagern, und dann, wenn die Bewegung des ersten Abstreifsystems (13a) noch nicht beendet ist, insbesondere in der Mitte der Bewegung, das wenigstens eine zweite Abstreifsystem (13b) zu verlagern.

9. Verfahren nach einem der vorhergehenden Ansprüche, **dadurch gekennzeichnet, dass** es eine Verlagerungssequenz des wenigstens einen ersten Abstreifsystems (13a) und zweiten Abstreifsystems (13b) implementiert, umfassend über einen vorbestimmten Zeitraum die gleichzeitige Verlagerung des wenigstens einen ersten (13a) und zweiten (13b) Abstreifsystems.

10. Verfahren nach einem der vorhergehenden Ansprüche, **dadurch gekennzeichnet, dass** es den Schritt des Druckens durch Siebdruck eines ersten Musters (M1) und eines zweiten Musters (M2) auf das wenigstens eine elektrische und/oder elektronische Bauteil (4) umfasst, wobei jedes Muster (M1, M2) gedruckte Linien (8) umfasst, die sich in derselben Richtung (D1, D2) erstrecken, wobei sich die gedruckten Linien (8) des ersten Musters (M1) in einer ersten Richtung (D1) erstrecken und sich die gedruckten Linien (8) des zweiten Musters (M2) in einer zweiten Richtung (D2) erstrecken, wobei die erste (D1) und die zweite (D2) Richtung im wesentlichen senkrecht zueinander sind.

11. Verfahren nach Anspruch 10, **dadurch gekennzeichnet, dass** die Abstreifbewegung des ersten Abstreifsystems (13a) gleich Δ + L₀/2 ist, wobei Δ zwischen 2 und 10 mm liegt und L₀ die Breite des wenigstens einen elektrischen und/oder elektronischen Bauteils (4) ist.

12. Verfahren nach Anspruch 11, **dadurch gekennzeichnet, dass** die Abstreifbewegung des zweiten Abstreifsystems (13b) gleich L₀+Δ ist.

13. Verfahren nach einem der vorhergehenden Ansprüche, **dadurch gekennzeichnet, dass** das wenigstens eine elektrische und/oder elektronische Bauteil (4) eine Halbleiterstruktur zur Herstellung einer Photovoltakzelle (4) ist.

14. Verfahren nach Anspruch 13, **dadurch gekennzeichnet, dass** die gedruckten Linien (8) Sammelfinger (8) bilden, und dass das Verfahren ferner den Schritt des Druckens von Leiterbahnen (9) umfasst, die im Wesentlichen senkrecht zu den gedruckten Linien (8) ausgerichtet sind.

15. Verfahren nach einem der vorhergehenden Ansprüche, **dadurch gekennzeichnet, dass** es die Ausführung eines digitalen Steuerungssystems zur Steuerung der Bewegungen des wenigstens einen ersten (13a) und zweiten (13b) Abstreifsystems umfasst, wobei dieses digitale Steuerungssystem insbesondere einen Antikollisionsalgorithmus umfasst.

## Claims

1. Method of screen printing on at least one electric and/or electronic component (4) of a number (d) of patterns (M1, M2) greater than or equal to two, each pattern (M1, M2) comprising printed lines (8) extending in the same direction (D1, D2), the printed lines (8) of two patterns (M1, M2) juxtaposed with one another extending respectively in first (D1) and second (D2) directions substantially perpendicular to one another, the method comprising the use of a screen printing plate (10) for forming the patterns (M1, M2) on said at least one electric and/or electronic component (4),
**characterised in that** the method further includes the use of at least one first doctor blade system (13a) and one second doctor blade system (13b) that are independent, configured respectively to enable the doctoring in the first direction (D1) and in the second direction (D2) in order to obtain a two-way doctoring for the printing of patterns (M1, M2).

2. Method according to claim 1, **characterised in that** the printing of patterns (M1, M2) is performed in only one step with a single screen printing plate (10).

3. Method according to claim 1 or 2, **characterised in that** said at least one first doctor blade system (13a) is configured to enable the doctoring in both ways of the first direction (D1) and **in that** said at least one second doctor blade system (13b) is configured to enable the doctoring in both ways of the second direction (D2) in order to obtain an alternate two-way doctoring for the printing of patterns (M1, M2).

4. Method according to one of the preceding claims, **characterised in that** the method is configured to print printed lines (8) of width (L2') between 20 and 130 µm, in particular less than 80 µm, in particular also less than 50 µm.

5. Method according to any one of the preceding claims, **characterised in that** the width (Lo) of said at least one electric and/or electronic component (4) is greater than or equal to 150 mm, in particular 156 mm.

6. Method according to any one of the preceding claims, **characterised in that** said at least one first doctor blade system (13a) has a width L1a defined by L1a = L₀ + y, where L₀ is the width of said at least one electric and/or electronic component (4) and y verifies the following relation 0 ≤ y ≤ 10 mm.

7. Method according to claim 6, **characterised in that** said at least one second doctor blade system (13b) has a width (L1b) defined by L1b = y + L₀/d, where d is the number of patterns (M1, M2).

8. Method according to any one of the preceding claims, **characterised in that** it implements a sequence of movements of said at least one first doctor blade system (13a) and one second doctor blade system (13b) consisting in moving first of all said at least one first doctor blade system (13a), then while the stroke of said first doctor blade system (13a) is not finished, in particular at midstroke, in moving said at least one second doctor blade system (13b).

9. Method according to any one of the preceding claims, **characterised in that** it implements a sequence of movements of said at least one first doctor blade system (13a) and one second doctor blade system (13b) comprising, over a predetermined duration, the simultaneous movement of said at least one first (13a) and one second (13b) doctor blade systems.

10. Method according to any one of the preceding claims, **characterised in that** it includes the step of screen printing on said at least one electric and/or electronic component (4) of a first pattern (M1) and of a second pattern (M2), each pattern (M1, M2) comprising printed lines (8) extending in the same direction (D1, D2), the printed lines (8) of the first pattern (M1) extending in a first direction (D1) and the printed lines (8) of the second pattern (M2) extending in a second direction (D2), the first (D1) and second (D2) directions being substantially perpendicular to one another.

11. Method according to claim 10, **characterised in that** the doctoring stroke of the first doctor blade system (13a) is equal to Δ + L₀/2, where Δ is between 2 and 10 mm, and L₀ is the width of said at least one electric and/or electronic component (4).

12. Method according to claim 11, **characterised in that** the doctoring stroke of the second doctor blade system (13b) is equal to L₀ + Δ.

13. Method according to any one of the preceding claims, **characterised in that** said at least one electric and/or electronic component (4) is a semiconductor structure for obtaining a photovoltaic cell (4).

14. Method according to claim 13, **characterised in that** the printed lines (8) constitute collection fingers (8), and **in that** the method also includes the step of printing conductor tracks (9) oriented substantially perpendicular in relation to the printed lines (8).

15. Method according to any one of the preceding claims, **characterised in that** it includes the implementation of a system for digitally controlling the strokes of said at least one first (13a) and one second (13b) doctor blade systems, this digital control system including in particular an anti-collision algorithm.
